# FASCICULE DE BREVET EUROPEEN

(11) **EP 0 780 865 B1**
(45) Date de publication et mention de la délivrance du brevet: **21.04.1999**
(21) Numéro de dépôt: 96402771.8
(22) Date de dépôt: 17.12.1996
(51) Int. Cl.: H01H 13/70, H03K 17/96

(54) **Dispositif à touche sensitive**
Berührungsempfindliche Vorrichtung
Touch sensitive device

(30) Priorité: 19.12.1995 FR 9515058
(43) Date de publication de la demande: 25.06.1997
(73) Titulaire: COMPAGNIE EUROPEENNE POUR L'EQUIPEMENT MENAGER CEPEM, F-45142 St Jean-de-la-Ruelle Cédex (FR)
(72) Inventeur: Bony, Jean-Michel, Thomson-CSF, 94117 Arcueil Cedex (FR); Frappereau, Fabrice, Thomson-CSF, 94117 Arcueil Cedex (FR); Kim Ly, Kha, Thomson-CSF, 94117 Arcueil Cedex (FR); Nugeyre, Jean-Pierre, Thomson-CSF, 94117 Arcueil Cedex (FR)
(74) Mandataire: Benoit, Monique

(56) Documents cités:
- FR-A- 2 704 332
- US-A- 3 950 846
- US-A- 4 056 699
- US-A- 4 090 229
- US-A- 4 584 444

## Description

La présente invention concerne les dispositifs à touche sensitive par effet capacitif utilisés notamment dans les claviers numériques, par exemple pour une table de cuisson.

Il est connu que de tels dispositifs permettent de détecter la présence d'un élément (doigt d'un utilisateur ou objet électriquement conducteur, par exemple une casserole métallique) à travers un corps électriquement isolant du type plaque de verre ou de vitrocéramique.

Plus précisément, le fait de placer le doigt ou un objet sur la plaque dans une zone en regard avec une touche sensitive engendre une variation de capacité. La touche est reliée électriquement à un circuit électronique qui détecte cette variation de capacité et la transforme en état actif ou non actif.

De nombreux modes de réalisation de touches fonctionnant selon le principe rappelé ci-dessus ont déjà été proposés.

Nous nous intéressons dans la suite aux modes de réalisation particuliers selon lesquels la touche et les composants formant notamment le circuit électronique de détection de l'activation de la touche sont portés par un support électriquement isolant placé derrière la plaque.

Dans un premier mode de réalisation connu, ce support électriquement isolant est composé de deux plaquettes de circuit imprimé maintenues à distance l'une en regard de l'autre, l'une des deux plaquettes portant essentiellement les touches obtenues par gravure, et l'autre portant essentiellement les composants électroniques. Dans un tel mode de réalisation, les difficultés d'assemblage des deux plaquettes en vue d'assurer leurs liaisons mécanique et électrique viennent grever considérablement les coûts de fabrication. En outre, le moindre défaut de planéité de la plaquette portant les touches, qui est appliquée contre la surface interne de la plaque transparente, entraîne la présence de lames d'air entre certaines touches et la plaque transparente. Il en résulte des dysfonctionnements dus à des différences de sensibilité entre les touches composant le clavier, voire à des insensibilités totales de certaines touches.

Pour pallier les inconvénients précédents, un deuxième mode de réalisation connu propose un support électriquement isolant constitué d'une plaquette de circuit imprimé unique portant simultanément les touches et les composants électroniques. Chaque touche comporte une tête électriquement conductrice reliée mécaniquement à la plaquette de circuit imprimé par un premier organe susceptible de se déplacer transversalement par rapport à la plaquette de circuit imprimé sous l'action d'un second organe constitué par un ressort électriquement conducteur. Le ressort permet d'une part, d'assurer la liaison électrique entre la tête de la touche et le circuit électronique, et d'autre part, le déplacement transversal du premier organe de façon à ce que la tête soit en appui contre la plaque transparente. Une telle réalisation est décrite dans le document FR-A-2.704.332. Elle permet de s'affranchir du problème des lames d'air évoqué précédemment, mais le nombre de pièces distinctes destinées à réaliser la touche reste élevé. Ces pièces doivent être fabriquées indépendamment les unes des autres, ce qui augmente le coût global de fabrication, et l'assemblage de ces pièces reste compliqué. Par ailleurs, les risques de défaut dans les contacts électriques sont élevés.

La présente invention a pour but de proposer un nouveau dispositif à touche sensitive par effet capacitif dans lequel la réalisation de la touche et son assemblage avec les autres éléments du dispositif sont considérablement simplifiés.

Plus précisément, la présente invention a pour objet un dispositif à touche sensitive par effet capacitif pour détecter la présence d'un élément à travers une plaque électriquement isolante, la touche étant portée par une plaquette de circuit imprimé sensiblement parallèle à ladite plaque et étant reliée électriquement à un circuit électronique de détection porté par ladite plaquette de circuit imprimé, caractérisé en ce que la touche est constituée par une pièce unique réalisée par une lame ressort en matériau électriquement conducteur présentant une embase fixée sur la plaquette de circuit imprimé et reliée par l'intermédiaire d'une partie médiane à une partie supérieure sensiblement plane formant une surface de détection destinée à être plaquée contre la surface inférieure de la plaque, la partie médiane permettant une flexibilité de la pièce en sorte que la surface de détection soit en appui élastique contre la surface inférieure de la plaque quels que soient les défauts de parallélisme entre la plaque et la plaquette de circuit imprimé.

Grâce à l'invention, une pièce unique permet d'assurer les trois fonctions indispensables à la transmission d'information, à savoir :
- la fonction touche grâce à la surface de détection en regard de laquelle l'utilisateur peut placer son doigt ou un objet ;
- la fonction ressort pour plaquer la surface de détection contre la plaque, quels que soient les défauts de cette dernière ;
- la connexion électrique entre la surface de détection et les composants portés par la plaquette de circuit imprimé.

Dans un mode de réalisation préférentiel de l'invention, la lame ressort est repliée en forme de Z. L'embase de la lame, sensiblement plane, forme avec la partie supérieure, les deux parties extrêmes du Z, la partie médiane étant constituée par la partie oblique du Z.

D'autres avantages vont apparaître au vu de la description d'un exemple de réalisation préférentiel de la pièce unique faite en référence aux figures annexées dans lesquelles :

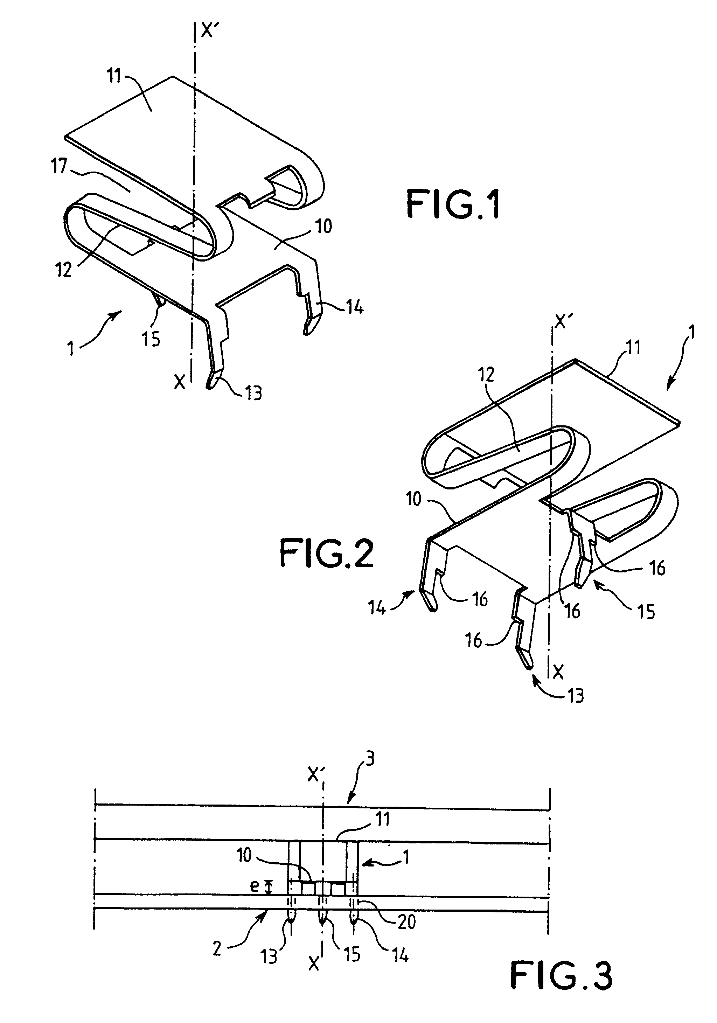

- les figures 1 et 2 sont des vues en perspective respectivement par le dessus et par le dessous, d'une pièce unique constituant la touche selon l'invention ;
- la figure 3 est une coupe en élévation montrant la mise en place de la touche sur la plaquette de circuit imprimé et sous la plaque.

Comme représentée sur les figures, la pièce unique constituant la touche selon l'invention et portant la référence 1 est réalisée par une lame ressort en matériau électriquement conducteur repliée en forme de Z, et présentant une embase 10, une partie supérieure 11, et une partie oblique 12 formant la partie médiane et reliant l'embase 10 et la partie supérieure 11.

L'embase 10 et la partie supérieure 11 sont sensiblement planes, et la partie oblique 12 est telle qu'elle permet une flexibilité de la pièce, notamment le long de l'axe XX'.

La pièce 1 est fixée sur la plaquette 2 de circuit imprimé au niveau de son embase 10, par exemple par l'intermédiaire de trois picots 13, 14 et 15 prolongeant l'embase sensiblement perpendiculairement et placés dans trois trous 20 correspondants de la plaquette 2 de circuit imprimé.

On peut souder ou braser tout ou partie des picots 13, 14 et 15 directement sur une piste conductrice reliée au circuit électronique de détection (non représentés). Ainsi, les picots permettent non seulement le maintien mécanique de la pièce 1, mais aussi sa connexion électrique avec le circuit électronique de détection porté par la plaquette.

Les picots sont avantageusement au nombre de trois, deux premiers picots 13 et 14 étant par exemple prévus à l'extrémité libre de l'embase 10, le troisième picot 15 étant prévu à l'extrémité opposée de l'embase, sensiblement à égale distance des deux premiers picots.

De préférence, chaque picot comprend un épaulement 16 qui vient en butée contre la surface supérieure de la plaquette 2 de circuit imprimé. De cette manière, on maintient un espacement e entre l'embase 10 et la plaquette 2. Des composants électroniques sont par conséquent susceptibles d'être implantés sur la plaquette et sous l'embase. Cet espacement peut également contribuer à l'amélioration d'une éventuelle opération de lavage de la plaquette 2 après soudage des composants électroniques et de la pièce 1 sur la plaquette 2.

Lorsque la plaquette 2 supportant la pièce 1 est placée sous la plaque 3 en matériau électriquement isolant et de préférence transparente, la partie supérieure 11 est plaquée contre la surface inférieure de cette plaque 3. Cette partie supérieure 11 constitue directement la surface de détection en regard de laquelle un utilisateur peut poser son doigt ou un objet. La partie oblique 12 permet une flexibilité de la pièce 1 en sorte que cette surface de détection soit en appui élastique contre la surface inférieure de la plaque, quels que soient les défauts de parallélisme entre la plaque 3 et la plaquette 2 de circuit imprimé.

La partie oblique 12 comporte de préférence un évidement central 17 sur toute sa longueur. Ainsi, la souplesse de la lame ressort 1 est ajustée afin qu'elle n'applique pas un effort trop important sur la plaque transparente 3 et sur la plaquette 2. Outre l'ajustement de l'effort de la lame ressort, l'évidement permet, à la compression de la pièce, de maintenir la surface supérieure 11 plane grâce à une rigidité supérieure à celle de la partie oblique.

Le matériau utilisé pour réaliser la pièce unique doit être électriquement conducteur, soudable à l'étain et élastique. On utilise par exemple du cuivre ou un alliage de cuivre.

La conception de la touche selon l'invention regroupe les avantages suivants :
■ Une pièce unique regroupant toutes les fonctions nécessaires au fonctionnement de la touche minimise le coût de fabrication.
■ L'assemblage de la pièce unique sur la plaquette de circuit imprimé fait appel à un processus industriel standard comprenant l'insertion de picots dans des trous de la plaquette et la soudure de ces picots.
■ L'interconnexion par soudure directe simplifie et fiabilise celle-ci.
■ Le fonctionnement de la touche est assuré quels que soient les défauts de parallélisme entre la plaquette de circuit imprimé et la plaque transparente.
■ Dans l'exemple de réalisation préférentiel décrit ci-dessus, la forme des picots permet de surélever l'embase par rapport à la plaquette de circuit imprimé, ce qui laisse la possibilité d'implanter des composants sous l'embase. L'encombrement est de ce fait optimisé.
■ Le poids de la pièce unique est faible, surtout lorsque la partie oblique comporte un évidement central, ce qui permet de plaquer la surface de détection contre la plaque transparente sans pour autant exercer une force trop importante sur cette plaque et sur la plaquette de circuit imprimé.

## Revendications

1. Dispositif à touche sensitive par effet capacitif pour détecter la présence d'un élément à travers une plaque (3) électriquement isolante, la touche étant portée par une plaquette de circuit imprimé (2) sensiblement parallèle à ladite plaque (3) et étant reliée électriquement à un circuit électronique de détection porté par ladite plaquette (2) de circuit imprimé, caractérisé en ce que la touche est constituée par une pièce unique (1) réalisée par une lame ressort en matériau électriquement conducteur présentant une embase (10) fixée sur la plaquette de circuit imprimé et reliée par l'intermédiaire d'une partie médiane (12) à une partie supérieure (11) sensiblement plane formant une surface de détection destinée à être plaquée contre la surface inférieure de la plaque (3), la partie médiane (12) permettant une flexibilité de la pièce en sorte que la surface de détection (11) soit en appui élastique contre la surface inférieure de la plaque (3) quels que soient les défauts de parallélisme entre la plaque (3) et la plaquette (2) de circuit imprimé.

2. Dispositif à touche selon la revendication 1, caractérisé en ce que la lame ressort est repliée en forme de Z, avec une embase (10) sensiblement plane constituant, avec la partie supérieure (11), les deux extrémités du Z, et la partie médiane (12) étant constituée par la partie oblique du Z.

3. Dispositif à touche selon la revendication 2, caractérisé en ce que la partie oblique (12) de la pièce en forme de Z possède un évidement central (17) sur toute sa longueur.

4. Dispositif à touche selon l'une quelconque des revendications précédentes, caractérisé en ce que ladite pièce (1) est fixée à la plaquette (2) de circuit imprimé au niveau de l'embase (10) par l'intermédiaire de picots (13, 14, 15) qui prolongent ladite embase (10) sensiblement perpendiculairement, placés dans des trous (20) de la plaquette (2) de circuit imprimé et soudés à celle-ci de manière à permettre le maintien mécanique de la pièce et la liaison électrique entre la surface de détection (11) et le circuit électronique de détection.

5. Dispositif à touche selon la revendication 4, caractérisé en ce que les picots comprennent un épaulement (16) qui vient en butée contre la surface supérieure de la plaquette (3) de circuit imprimé de manière à maintenir un espacement (e) entre l'embase (10) et ladite plaquette pour la mise en place éventuelle de composants sous l'embase.

6. Dispositif à touche selon l'une quelconque des revendications 4 et 5, caractérisé en ce que les picots sont au nombre de trois.

7. Dispositif à touche selon la revendication 6, caractérisé en ce que deux premiers picots (13, 14) sont prévus à l'extrémité libre de l'embase (10), un troisième picot (15) étant prévu à l'extrémité opposée, sensiblement à égale distance des deux premiers picots.

8. Dispositif à touche selon l'une quelconque des revendications précédentes, caractérisé en ce que le matériau utilisé pour la pièce unique comporte du cuivre.

## Patentansprüche

1. Vorrichtung mit durch kapazitive Wirkung sensitiver Taste zum Erfassen des Vorhandenseins eines Elementes durch eine elektrisch isolierende Platte (3) hindurch, wobei die Taste von einer Leiterplatte (2) getragen ist, die im wesentlichen parallel zu der Platte (3) und elektrisch mit einer auf der Leiterplatte (2) angeordneten elektronischen Erfassungsschaltung verbunden ist, dadurch gekennzeichnet, daß die Taste aus einem einzigen Bauteil (1) besteht, das durch ein Federblatt aus elektrisch leitfähigem Material verwirklicht ist, das eine Grundplatte (10) aufweist, die auf der Leiterplatte befestigt und über einen mittleren Teil (12) mit einem oberen Teil (11) verbunden ist, der im wesentlichen eben ist und eine Erfassungsfläche bildet, die gegen die untere Fläche der Platte (3) gedrückt werden kann, wobei der mittlere Teil (12) dem Bauteil eine solche Flexibilität gibt, daß die Erfassungsfläche unabhängig von Abweichungen der Parallelität zwischen der Platte (3) und der Leiterplatte (2) elastisch an der unteren Fläche der Platte (3) abgestützt ist.

2. Vorrichtung mit Taste nach Anspruch 1, dadurch gekennzeichnet, daß das Federblatt in Form eines Z gebogen ist, mit einer im wesentlichen ebenen Grundplatte (10), die mit dem oberen Teil (11) die beiden Enden des Z bildet, wobei der mittlere Teil (12) durch den schrägen Teil des Z gebildet ist.

3. Vorrichtung mit Taste nach Anspruch 2, dadurch gekennzeichnet, daß der schräge Teil (12) des Bauteils in Form eines Z auf seiner gesamten Länge eine zentrale Aussparung (17) aufweist.

4. Vorrichtung mit Taste nach einem der vorstehenden Ansprüche, dadurch gekennzeichnet, daß das Bauteil (1) auf Höhe der Grundplatte (10) an der Leiterplatte (2) über Spitzen (13, 14, 15) befestigt ist, die die Grundplatte (10) im wesentlichen senkrecht verlängern und die in Löchern (20) der Leiterplatte (2) angeordnet und mit dieser verlötet sind, so daß das Bauteil mechanisch gehalten ist und die elektrische Verbindung zwischen der Erfassungsfläche (11) und der elektronischen Erfassungsschaltung besteht.

5. Vorrichtung mit Taste nach Anspruch 4, dadurch gekennzeichnet, daß die Spitzen einen Absatz (16) aufweisen, der an die obere Fläche der Leiterplatte (3) in Anlage gelangen, so daß zwischen der Grundplatte (10) und der Leiterplatte ein Abstand (e) vorliegt, um eventuell Bauteile unter der Grundplatte anzubringen.

6. Vorrichtung mit Taste nach einem der Ansprüche 4 und 5, dadurch gekennzeichnet, daß drei Spitzen vorgesehen sind.

7. Vorrichtung mit Taste nach Anspruch 6, dadurch gekennzeichnet, daß die beiden ersten Spitzen (13, 14) am freien Ende der Grundplatte (10) vorgesehen sind und daß eine dritte Spitze (15) am gegenüberliegenden Ende, im wesentlichen im gleichen Abstand von den beiden ersten Spitzen, vorgesehen ist.

8. Vorrichtung mit Taste nach einem der vorstehenden Ansprüche, dadurch gekennzeichnet, daß das für das einzige Bauteil verwendete Material Kupfer aufweist.

## Claims

1. Capacitive-effect touch pad device for detecting the presence of an element through an electrically insulating plate (3), the pad being carried by a printed-circuit board (2) substantially parallel with the said plate (3) and being linked electrically to an electronic detection circuit carried by the said printed-circuit board (2), characterized in that the pad consists of a single part (1) made as a sprung strip of electrically conducting material having a base (10) fixed to the printed-circuit board and linked by way of a middle portion (12) to a substantially plane upper portion (11) forming a detection surface intended to be applied flat against the lower surface of the plate (3), the middle portion (12) allowing flexibility of the part so that the detection surface (11) bears elastically against the lower surface of the plate (3) irrespective of any lack of parallelism between the plate (3) and the printed-circuit board (2).

2. Pad device according to Claim 1, characterized in that the sprung strip is bent into a Z shape, with a substantially plane base (10) constituting, together with the upper portion (11), the two ends of the Z, and the middle portion (12) consisting of the oblique portion of the Z.

3. Pad device according to Claim 2, characterized in that the oblique portion (12) of the Z-shaped part possesses a central recess (17) over the whole of its length.

4. Pad device according to any one of the preceding claims, characterized in that the said part (1) is fixed to the printed-circuit board (2) in the vicinity of the base (10) by way of prongs (13, 14, 15) which extend the said base (10) substantially perpendicularly, are placed in holes (20) in the printed-circuit board (2) and are soldered to the latter so as to allow mechanical retention of the part and electrical linking between the detection surface (11) and the electronic detection circuit.

5. Pad device according to Claim 4, characterized in that the prongs comprise a shoulder (16) which abuts against the upper surface of the printed-circuit board (3) in such a way as to maintain a gap (e) between the base (10) and the said board for the possible installing of components under the base.

6. Pad device according to either one of Claims 4 and 5, characterized in that there are three prongs.

7. Pad device according to Claim 6, characterized in that two first prongs (13, 14) are provided at the free end of the base (10), a third prong (15) being provided at the opposite end, substantially equidistant from the two first prongs.

8. Pad device according to any one of the preceding claims, characterized in that the material used for the single part comprises copper.
